# EUROPEAN PATENT APPLICATION

(11) **EP 1 638 113 A1**
(43) Date of publication of application: **22.03.2006**
(21) Application number: 04736804.8
(22) Date of filing: 14.06.2004
(51) Int. Cl.: H01B 13/00, H01B 12/10

(54) **BISMUTH OXIDE SUPERCONDUCTING WIRE ROD AND PROCESS FOR PRODUCING THE SAME**

(30) Priority: 26.06.2003 JP 2003183474
(71) Applicant: Sumitomo Electric Industries, Ltd., Osaka-shi, Osaka 541-0041 (JP)
(72) Inventor: AYAI, Naoki Osaka Works Sumitomo Electric Ind.Ltd, Osaka-shi, Osaka 5540024 (JP)
(74) Representative: Kreutzer, Ulrich
(86) International application number: PCT/JP2004/008668
(87) International publication number: WO 2005/001852

(57) **Abstract**

The present invention provides a method of manufacturing a bismuth based oxide superconducting wire, comprising steps of preparing a raw material powder, and subjecting the raw material powder to plastic working and heat treatment; wherein the raw material powder contains the superconducting phases containing Bi, Pb, Sr, Ca, Cu, and O in a composition ratio of approximately 2:2:1:2 (Bi+Pb):Sr:Ca:Cu, and the non-superconducting phases containing Pb; wherein the composition ratio (Bi+Pb):Sr:Ca:Cu of the raw material powder is approximately 2:2:2:3; and wherein the ratio of the non-superconducting phases to the superconducting phases is 5 wt% or less; or wherein the raw material powder contains orthorhombic superconducting phases containing Bi, Pb, Sr, Ca, Cu, and O in a composition ratio of approximately 2:2:1:2 (Bi+Pb):Sr:Ca:Cu; and wherein the composition ratio (Bi+Pb):Sr:Ca:Cu of the raw material powder is approximately 2:2:2:3.

## Description

### Technical Field

The present invention relates to a method of manufacturing a bismuth based oxide superconducting wire. More particularly, it relates to a method of manufacturing a bismuth based oxide superconducting wire containing Bi-2223 phase as the primary phase, wherein Bi, Pb, Sr, Ca, Cu, and O are contained in a composition ratio (molar ratio) of approximately 2:2:2:3 (Bi+Pb):Sr:Ca:Cu.

### Background Art

It is known that a bismuth based oxide superconducting wire has a high critical temperature and a high critical current density and that particularly a Bi-2223 oxide superconducting wire containing Bi-2223 phase as the primary phase has a high critical temperature of approximately 110 K.

The Bi-2223 oxide superconducting wire can be manufactured by filling a raw material powder containing powdered Bi₂O₃, PbO, SrCO₃, CaCO₃, CuO, etc. in a metal sheath (metal tube), subjecting the metal sheath to plastic working such as wire drawing and rolling working so as to obtain filaments containing Bi, Pb, Sr, Ca, Cu, and O, and thereafter performing heat treatment on the filaments. Here, heat treatment is performed to form the Bi-2223 phases and to bond strongly the generated crystal grains together.

Various methods of manufacturing the Bi-2223 oxide superconducting wire have been proposed to obtain a high critical current value and a high critical current density.

For example, the method proposed in Japanese Patent No. 3074753 is such that a raw material powder mainly containing the Bi-2212 phases in a composition ratio (molar ratio) of approximately 2:2:1:2 (Bi+Pb):Sr:Ca:Cu and partially containing the Bi-2223 phases and non-superconducting phases is filled in a metal sheath and the metal sheath filled with the material is subjected to plastic working and heat treatment. This method promotes the formation of the Bi-2223 phases by heat treatment and enables a high critical current value, a high critical current density, and an excellent magnetic field property of high critical current density by causing fine distribution of non-superconducting phases.

Also, Japanese Patent Application Laid-open No. 2002-75091 discloses a method of manufacturing an oxide superconducting wire which is characterized by using a raw material powder whose maximum grain size is smaller than the minor axis of the filament section before compressive deformation in one axial direction. It is a method in which the critical current value is enhanced to the maximum limit by choosing the optimum maximum grain size corresponding to the diameter of the filament.

However, the present inventors found that these conventional methods had problems as described below.

Even if the raw material powder whose grain size is adjusted by micronization according to the method described in, for example, Japanese Patent Application Laid-open No. 2002-75091 is used, the non-superconducting phases coagulate and coarsen in the formation process of the Bi-2223 phases, resulting in the decrease in the critical current density.

Namely, among the constituent phases contained in a raw material powder of a Bi-Pb-Sr-Ca-Cu-O based oxide superconductor, the non-superconducting phases containing Pb such as (Ca+Sr)₂PbO ₄ and (Pb+Bi)₃(Sr+Ca+Bi)₅CuO _{12+δ} have a melting temperature lower than the other constituent phases such as the Bi-2212 phases and Ca-Sr-Cu-0 and are easily coagulated in the formation process of the Bi-2223 phases. Thus, the non-superconducting phases coagulate so as to have a coarsened structure in the superconducting wires of the end products, giving rise to the decrease in the critical current density.

Also, the superconducting phases contained in the filament that has been subjected to plastic working and that has not been heat-treated are not necessarily orientated such that non-oriented crystals with a large angle to the interface between the filament and the surrounding matrix exist. In addition, the Bi-2212 superconducting phases of tetragonal crystal are liable to grow in the a-b axis direction and therefore grow larger in the a-b axis direction at a lower temperature and within a shorter time than the Bi-2223 phases. Therefore, the crystals of the Bi-2212 phases grow out of the interface into the matrix in the formation process of the Bi-2223 phases by heat treatment and the smoothness of the interface is lost. Voids are also generated by the collision of crystals with different orientation and the density inside the filament decreases. As a result, the Bi-2223 phases formed thereafter become low in orientation and density such that crystals do not grow in the direction of the c axis, and accordingly the critical current density is lowered.

### Disclosure of Invention

Thus, in order to resolve these problems, the present inventors have developed a method of manufacturing an oxide superconducting wire having a higher critical current and a higher critical current density.

Namely, a main object of the present invention is to provide a method of manufacturing a bismuth based oxide superconductor having a high critical current density by inhibiting coagulation of the non-superconducting phases as well as improving the orientation of the Bi-2223 crystals.

The above object can be first attained by lowering the ratio of the non-superconducting phases to the Bi-2212 phases in the raw material powder to a predetermined value or less.

In other words, according to a first aspect of the present invention, there is provided a method of manufacturing a bismuth based oxide superconducting wire, which method is characterized by the steps of preparing a raw material powder and subjecting the raw material powder to plastic working and heat treatment; wherein the raw material powder contains non-superconducting phases containing Pb and superconducting phases comprising Bi, Pb, Sr, Ca, Cu, and O in a composition ratio of approximately 2:2:1:2 (Bi+Pb):Sr:Ca:Cu; and wherein the ratio of the non-superconducting phases to the superconducting phases is 5 wt% or less.

The present inventors found that coagulation of the non-superconducting phases containing Pb could be inhibited in the formation process of the Bi-2223 phases when the ratio of the non-superconducting phases containing Pb to the Bi-2212 phases in the raw material powder was 5 wt% or less. Since coagulation of the non-superconducting phases can be inhibited, the formation of the non-superconducting phases with the coarsened structure is also inhibited and a high critical current density can be obtained.

The term "non-superconducting phases containing Pb" as used herein means the non-superconducting phases containing Pb and existing in a raw material powder: for example, they are (Ca+Sr)₂PbO₄, (Pb+Bi)₃(Sr+Ca+Bi)₅CuO_{12+δ}. On the other hand, the non-superconducting phases that do not contain Pb are Sr-Ca-Cu-O and Ca-Cu-O, for example.

In this specification, raw material powder, as the term is used herein, means the raw material powder just before filling in a metal sheath and can be obtained by pulverization and mixing of the raw materials such as Bᵢ₂O₃, PbO, SrCO₃, CaCO₃, and CuO.

Either pulverization or mixing may be performed first or both may be performed simultaneously. When the grain size of the powder is large, the formation of the Bi-2223 phases by heat treatment and the strong bonding of the generated crystal grains tend to be inhibited. Since this tendency becomes significant particularly when the maximum grain size is similar to or larger than the diameter of the superconducting filament in the superconducting wire described later, it is generally preferable that the maximum grain size be 10 µm or less and the average grain size be 3 µm or less.

A raw material powder according to the first aspect of the present invention contains, as the essential components and with a specified ratio, the Bi-2212 phases and the non-superconducting phases containing Pb. The raw material powder can be obtained by the pulverization and mixing, and thereafter by further performing heat treatment under predetermined conditions. For example, it can be also obtained by the method in a predetermined temperature range and oxygen partial pressure range as described later.

A raw material powder according to the first aspect of the present invention may contain small amounts of other phases, for example, the Bi-2223 phases other than the Bi-2212 phases and the non-superconducting phases containing Pb.

The raw material powder obtained as described above is filled in a metal sheath, thereafter plastic working and heat treatment are performed.

The metals or alloys with a low electric resistance that do not react with the bismuth based oxide superconductor are preferably used as the materials of the metal sheath. Silver or silver alloys are particularly preferable. The silver alloys include silver-manganese alloy. The metal sheath may be a devised metal tube wherein, for example, a silver-manganese alloy is used on the outer circumference side of the metal tube and pure silver is used on the inner circumference side thereof which contacts with the bismuth based oxide superconductor.

Preferably, the raw material powder is degassed before filling in a metal sheath. Degassing can prevent cracking of the superconductor and swelling of the metal sheath caused by expansion of the gas under heat treatment, and the like. Degassing is performed by heat treatment at a high temperature of, for example, 600 to 850°C for a short time of approximately 10 minutes to 1 hour.

Plastic working is performed on the metal sheath filled with the raw material powder such that the filament (wire) is formed. The wire fabrication process is performed, for example, as follows.

First, the metal sheath filled with the raw material powder is subjected to wire drawing so as to produce a clad wire in which the raw material powder is processed into a core material covered with the material of the metal sheath. The multiple cladded wires thus obtained are bundled and inserted into a metal tube again. Thereafter wire drawing is performed on it so as to produce a multifilament wire (wire) in which the raw material powder is processed to be filamentary in a state where a number of filaments are embedded in the metal sheath.

The multifilament wire thus obtained is processed into a tape shape by compressing mechanically from the up and down sides (rolling working). The aspect ratio (width/thickness of the tape shape) of the tape is not particularly limited, although the aspect ratio of approximately 10 to 30 is generally used.

The tape wire thus obtained by rolling working has a structure in which ribbon filaments of the raw material powder mixture are embedded into a tape metal sheath (matrix). In the filaments, the Bi-2212 phases and other phases exist as polycrystals.

Heat treatment is performed on the tape wire. "Heat treatment", as the term is used herein, means the heat treatment for Bi-2223 phase formation and is different from the heat treatment on the raw material powder formation described later.

The heat treatment is usually performed in two steps, between which re-rolling working is performed (see the 1st column of Japanese. Patent No. 2855869, and SEI technical review, Sumitomo Electric Industries, Ltd. No. 159, p. 124, Sep. 2001). The Bi-2223 phase is mainly generated in the first-step of the heat treatment (primary heat treatment).

Re-rolling working with a small reduction ratio is usually performed after the primary heat treatment to crush the voids formed by this heat treatment. The second step of the heat treatment (secondary heat treatment) is performed after re-rolling mainly to bond the generated crystal grains strongly together.

The above-mentioned plastic working and heat treatment may be repeated several times to increase a critical current density. For example, a high reduction ratio may be achieved by repeating a relatively low reduction ratio per pass several times.

According to a second aspect of the present invention, there is provided a method of manufacturing a bismuth based oxide superconducting wire, which method is characterized by the steps of preparing a raw material powder and subjecting the raw material powder to plastic working and heat treatment; wherein the raw material powder contains orthorhombic superconducting phases comprising Bi, Pb, Sr, Ca, Cu, and O in a composition ratio of approximately 2:2:1:2 (Bi+Pb):Sr:Ca:Cu.

The orthorhombic Bi-2212 phase has a melting temperature higher than the tetragonal Bi-2212 phases and its crystal growth in the direction of a-b axis is slow. Therefore, such problems as exhibited by the tetragonal Bi-2212 phases are decreased, that is, the problem in which the smoothness of the interface is lost as the crystals of the Bi-2212 phases grow out of the interface into the matrix during the heat treatment for the formation of the Bi-2223 phases and the problem in which the density inside the filament decreases due to voids generated by the collisions of crystals of different orientations are decreased. As a result, the orientation and the density of the Bi-2223 phases formed thereafter can be improved and thus the critical current density can be increased.

The raw material powder according to the second aspect contains the orthorhombic Bi-2212 phases as constituents. The orthorhombic system cannot be obtained from raw material that does not contain Pb but can be generally obtained from raw material containing Pb of approximately 10 at% or more to Bi.

The raw material powder containing the orthorhombic Bi-2212 phases as constituents can be obtained by using a raw material containing Pb of approximately 10 at% or more relative to Bi, performing pulverization and mixing under the same conditions as those according to the first aspect described, and thereafter performing further heat treatment under the predetermined condition. For example, it can also be obtained by a method in which a predetermined range of temperature and oxygen partial pressure are adopted as described later.

According to the second aspect, an oxide superconducting wire can also be obtained by performing plastic working and heat treatment on the raw material powder.

The conditions of plastic working and heat treatment, the instrument used, and the conditions of pretreatment, etc. are the same as those according to the first aspect.

As described above, an oxide superconducting wire can be obtained by further performing heat treatment on the raw material powder according to the first aspect under the predetermined conditions, that is, the raw material powder containing the Bi-2212 phases and the non-superconducting phases containing Pb, wherein the ratio of the non-superconducting phases to the Bi-2212 phases is 5 wt% or less; or the raw material powder according to the second aspect, that is, the raw material powder wherein B₁₂O₃, PbO, SrCO₃, CaCO₃, CuO, etc. are mixed to the orthorhombic Bi-2212 phases. A preferred example is the method of performing heat treatment at 650 to 730 °C and at the oxygen partial pressure of 0.02 atm or less. The third aspect of the present invention corresponds to this preferred example and is the method of manufacturing an oxide superconducting wire characterized by using the raw material powder under the conditions.

That is, the third aspect of the present invention provides a method of manufacturing a bismuth based oxide superconducting wire characterized by the steps of preparing a raw material powder, performing heat treatment on a raw material powder at 650 to 730°C at the oxygen partial pressure of 0.02 atm or less; and further performing plastic working and heat treatment on the raw material powder after the heat treatment; wherein the raw material powder contains Bi, Pb, Sr, Ca, Cu, and O in composition ratios (Bi+Pb):Sr:Ca:Cu of approximately 2:2:2:3.

Preferably, the raw material powder comprising Bi, Pb, Sr, Ca, Cu, and O in composition ratios (Bi+Pb):Sr:Ca:Cu of approximately 2:2:2:3 contains the Bi-2212 phases and the non-superconducting phases such as Ca-Sr-Cu-O, (Ca+Sr)₂PbO₄, and (Pb+Bi)₃(Sr+Ca+Bi)₅CuO_{12+δ}. Such powder can be obtained by performing pulverization and mixing of the raw materials such as Bi₂O₃, PbO, SrCO₃, CaCO₃, and CuO so that (Bi+Pb):Sr:Ca:Cu becomes approximately 2:2:2:3, and thereafter performing suitable heat treatment.

The raw material powder containing the Bi-2212 phases and the non-superconducting phases containing Pb, wherein the ratio of the non-superconducting phases to the Bi-2212 phases is 5 wt% or less can be obtained by performing heat treatment on such a powder at 600 to 750°C and at the oxygen partial pressure of 0.02 atm or less preferably for approximately 30 minutes to 20 hours. When the raw material containing approximately 10 at% of Pb to Bi is used, the raw material powder containing the orthorhombic Bi-2212 phases can be obtained. Therefore, the bismuth based oxide superconducting wire having an excellent critical current density can be obtained by performing plastic working and heat treatment on this raw material.

However, the ratio of the non-superconducting phases containing Pb to the Bi-2212 phases in the raw material powder may be increased in the process of degassing processing, plastic working, and various heat treatments performed before heat treatment for Bi-2223 phase formation. Moreover, the orthorhombic Bi-2212 phases may also change to other crystal systems in this process.

Therefore, preferably the wire before heat treatment for the Bi-2223 phase formation contains the Bi-2212 phases and the non-superconducting phases containing Pb, and the ratio of the non-superconducting phases to the Bi-2212 phases is 5 wt% or less; or preferably it contains the orthorhombic Bi-2212 phases.

However, when degassing processing, plastic working, and the various heat treatments performed before heat treatment for Bi-2223 phase formation are performed under the conditions generally adopted, the bismuth based oxide superconducting wire having an excellent critical current density can be obtained if the raw material powder corresponds to the conditions specified in the first and the second aspects of the present invention.

If the wire before heat treatment for Bi-2223 phase formation contains the Bi-2212 phases and the non-superconducting phases containing Pb, and if the ratio of (Ca+Sr)₂PbO₄ to the Bi-2212 phases is 5 wt% or less, a bismuth based oxide superconducting wire having an excellent critical current density can be obtained.

### Brief Description of the Drawings

Figure 1 shows the relation between the ratio of the non-superconducting phases containing Pb to the Bi-2212 phases and the critical current density (Jc).
Figure 2 shows the relations between the heat treatment temperature and the critical current density (Jc) for the orthorhombic Bi-2212 phases and the tetragonal Bi-2212 phases, respectively.
Figure 3 shows the relations between the heat treatment temperature and the critical current density (Jc) for the Bi-2212 phases heat-treated under various oxygen partial pressures.

### Best Mode for Carrying Out the Invention

Embodiments of the present invention will now be described in more detail by an example, but the scope of the present invention should not be limited to the following example.

### Example

Bi₂O₃, PbO, SrCO₃, CaCO₃ and CuO were mixed so that the composition ratio of Bi:Pb:Sr:Ca:Cu became 1.8:0.33:1.9:2.0:3.0. The raw material powder with the average grain size of 2 µm and the maximum grain size of 10 µm or less containing the (Bi+Pb)₂Sr₂CaCu₂Oₓ superconducting phases (Bi-2212 phases), Ca-Sr-Cu-O, (Ca+Sr)₂PbO₄, (Pb+Bi)₃(Sr+Ca+Bi)₅CuO_{12+δ} (3321 phases) etc. was produced by repeating heat treatment at the temperature between 700 to 860°C, pulverization, and mixing of the mixed powder a plurality of times. Heat treatment was performed on the powder at a predetermined oxygen partial pressure and at a predetermined temperature for 10 hours, thereafter the ratio of the non-superconducting phases containing Pb to the Bi-2212 phases was estimated using Rietveld X-ray diffraction method. The superconducting phases were considered as orthorhombic in the case where the modulation peaks (e.g. 021, 114) of the Bi-2212 phases disappeared completely and the peaks of 200 and 020 were separate.

Single-core wires were produced by drawing silver pipes filled with the obtained raw material powder into elongated bodies. The single-core wires were cut and fifty-five thereof were bundled and inserted into a silver pipe so as to form a multifilament wire by drawing it. The multifilament wires thus obtained were rolled and processed into tape-shaped bodies having a width of 4 mm and a thickness of 0.2 mm. The tape-shaped bodies were subjected to heat treatment for 30 hours at the temperature of 835°C in the atmosphere of the oxygen partial pressure of 0.08 atm so as to form Bi-2223 phases. Subsequently, they were subjected to interim rolling working and thereafter subjected to heat treatment further for 50 hours at the temperature of 825°C in the atmosphere of the oxygen partial pressure of 0.08 atm. The critical current of the wires thus obtained was measured at 77 K in a self magnetic field.

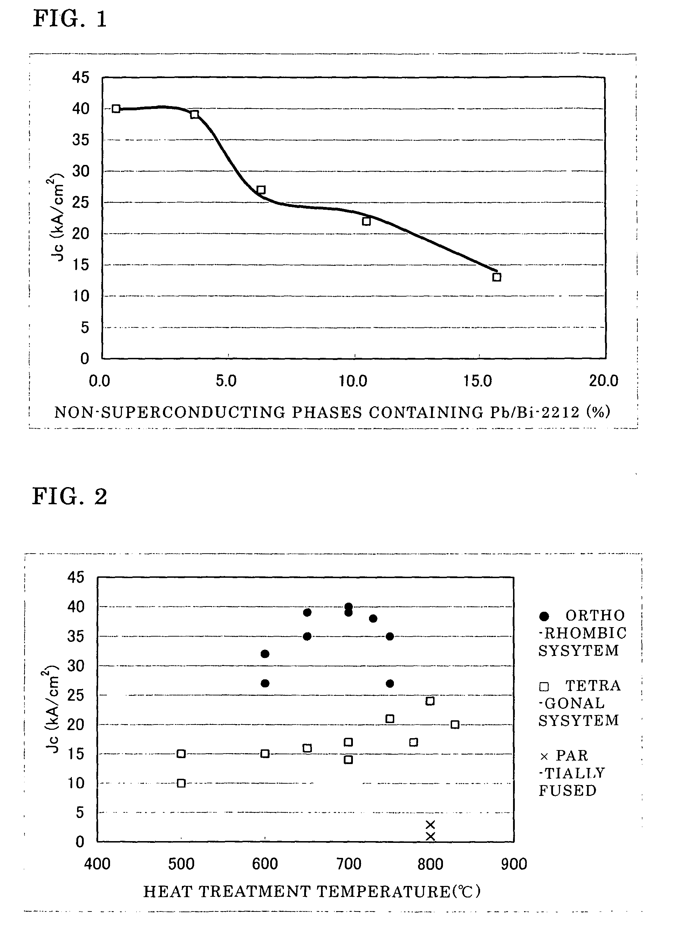

When the ratio of the non-superconducting phases containing lead was 5 wt% or less, the high critical current density of approximately 40 kA/cm² was obtained as shown in Fig. 1.

Also, as shown in Fig. 2, a high critical current density of 25 kA/cm² or more was obtained in the case where the Bi-2212 phases were orthorhombic.

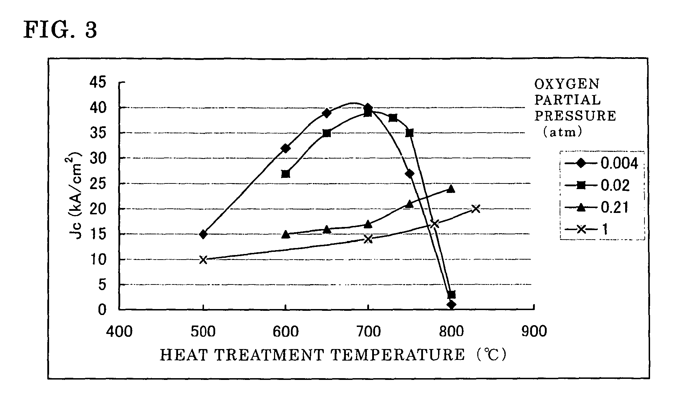

Also, as shown in Fig. 3, a high critical current density of approximately 30 kA/cm² or more was obtained by performing heat treatment on the powder at 600 to750°C and at the oxygen partial pressure of 0.02 atm or less.

### Industrial Applicability

A bismuth based oxide superconducting wire having a high critical current density can be manufactured according to the methods of the present invention as described above.

## Claims

1. A method of manufacturing a bismuth based oxide superconducting wire, **characterized by** the steps of preparing a raw material powder and subjecting the raw material powder to plastic working and heat treatment;
wherein the raw material powder contains superconducting phases comprising Bi, Pb, Sr, Ca, Cu, and O in a composition ratio of approximately 2:2:1:2 (Bi+Pb):Sr:Ca:Cu and non-superconducting phases containing Pb;
wherein the composition ratio (Bi+Pb):Sr:Ca:Cu of the raw material powder is approximately 2:2:2:3; and
wherein the ratio of the non-superconducting phases to the superconducting phases is 5 wt% or less.

2. A method of manufacturing a bismuth based oxide superconducting wire, **characterized by** the steps of preparing a raw material powder and subjecting the raw material powder to plastic working and heat treatment;
wherein the raw material powder contains orthorhombic superconducting phases comprising Bi, Pb, Sr, Ca, Cu, and O in a composition ratio of approximately 2:2:1:2 (Bi+Pb):Sr:Ca:Cu; and
wherein the composition ratio (Bi+Pb):Sr:Ca:Cu of the raw material powder is approximately 2:2:2:3.

3. A method of manufacturing a bismuth based oxide superconducting wire, **characterized by** the steps of:
preparing a raw material powder,
subjecting the raw material powder to heat treatment at 600°C to 750°C and at oxygen partial pressure of 0.02 atm or less; and
further performing plastic working and heat treatment on the raw material powder after the heat treatment;
wherein the raw material powder contains Bi, Pb, Sr, Ca, Cu, and O in a composition ratio of approximately 2:2:2:3 (Bi+Pb):Sr:Ca:Cu.

4. A bismuth based oxide superconducting wire obtained by the manufacturing method according to any one of claims 1 to 3.
